# EUROPÄISCHE PATENTSCHRIFT

(11) **EP 0 257 377 B1**
(45) Veröffentlichungstag und Bekanntmachung des Hinweises auf die Patenterteilung: **17.02.1993**
(21) Anmeldenummer: 87111272.8
(22) Anmeldetag: 04.08.1987
(51) Int. Cl.: H03H 9/25, H03H 9/02

(54) **Oberflächenwellen-Resonatorstruktur mit in Teilstücke unterbrochenen Metallisierungsstreifen von Reflektorfingern**
Surface wave resonator structure comprising reflective finger metallization strips divided into parts
Structure de résonateur à ondes de surface comportant des bandes métallisées de doigts réflecteurs divisées en parties

(30) Priorität: 29.08.1986 DE 3629464
(43) Veröffentlichungstag der Anmeldung: 02.03.1988
(73) Patentinhaber: SIEMENS AKTIENGESELLSCHAFT, 80333 München (DE)
(72) Erfinder: Grassl, Hans-Peter, Dr. Dipl.-Phys., D-8011 Zorneding (DE); Zibis, Peter, Dipl.-Ing., D-8000 München 83 (DE)

(56) Entgegenhaltungen:
- EP-A- 0 024 927
- EP-A- 0 098 116
- EP-A- 0 124 019
- DE-A- 2 346 204
- DE-A- 3 013 074
- US-A- 4 006 438

## Beschreibung

Die vorliegende Erfindung bezieht sich auf ein Oberflächenwellen-Resonatorfilter wie es im Oberbegriff des Patentanspruches 1 angegeben ist.

Aus der europäischen Patentanmeldung 01 24 019 A2 ist eine Oberflächenwellen-Resonatorstruktur nach dem Oberbegriff des Patentanspruches 1 bekannt. Bezüglich der Einzelheiten eines solchen Resonatorfilters sei auf diese Druckschrift hingewiesen. In dieser Druckschrift sind außerdem in den Seiten 1 bis 3 weitere Ausführungen über Stand der Technik gemacht, der technologische Hintergrund eines Resonatorfilters gemäß der genannten europäischen Patentanmeldung ist.

Andere Oberflächenwellen-Anordnungen mit in ihrer Längsrichtung unterbrochenen Fingerelektroden bzw. Resonatorstreifen sind bekannt aus der DE-A-34 04 618 und der US-A-4 267 534. Der letztgenannten Patentschrift entspricht inhaltlich die Druckschrift "Electronics Letters", Bd. 16 (1980), S. 793 - 794.

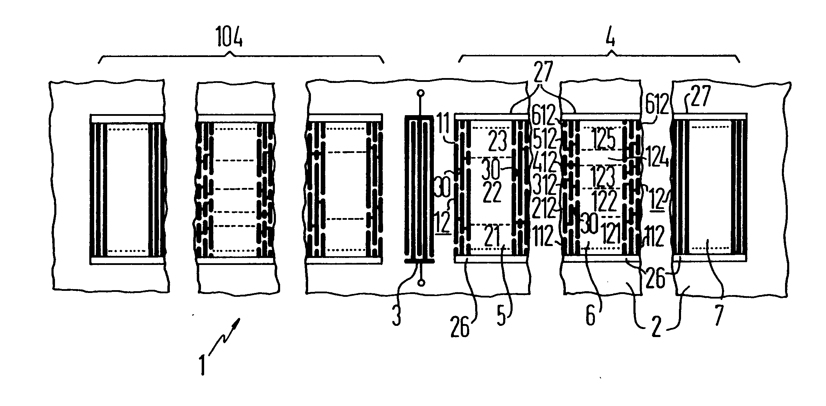

Aus der US-A-4 365 220 sind Oberflächenwellen-Anordnungen bekannt, die in Richtung quer zur Wellenfortpflanzungsrichtung abbrechende Elektrodenfinger bzw. Reflektorfinger besitzen, die aber stufenförmige Versätze aufweisen, so daß diese Elektroden bzw. Streifen keine Unterbrechungen in ihrer Längsrichtung haben. Eine dort in Figur 9b gezeigte Ausführungsform besitzt zwar Fingerunterbrechungen mit mehr oder weniger großen Lücken, jedoch sind die dort vorhandenen Teilstücke der einzelnen Elektroden bzw. Streifen voneinander getrennt.

Aus der EP-A-0 024 927 ist eine Oberflächenwellen-Resonatorstruktur bekannt, deren Reflektoren solche Metallisierungsstreifen aufweisen, die an ihren äußeren Enden durch Bus-Bars, wie häufig vorgesehen miteinander verbunden sind und die jeweils zwei oder mehr Unterbrechungen in Längsrichtungen aufweisen. Diese Unterbrechungen sind aber zwischen den Metallisierungsstreifen nicht verteilt angeordnet, sondern jeweilige Teilstücke der Metallisierungsstreifen der jeweiligen Resonatorstruktur sind untereinander gleich lang und mit ihren jeweiligen Enden gestreckt nebeneinander liegend angeordnet. Mit einer solchen Struktur kann die der voranstehend genannten europäischen Patentanmeldung 0 124 019 zugrundeliegende Aufgabe nicht lösen, einen infolge von Unterdrückung des Entstehens von Quermoden von Nebenmaxima freien Verlauf der Gruppenlaufzeit zu erzielen. Gerade diese Aufgabe soll aber mit der Erfindung in noch weiter optimierter Weise gelöst werden.

Noch weiteren Stand der Technik beschreibt die Druckschrift US-A-4 006 438, die einen Wandler mit interdigitaler Anordnung und Polung der Finger angibt. Dieser Wandler umfaßt in seinen in Richtung, der Wellenausbreitung gelegenen Endbereichen Strukturen, die den beanspruchten Strukturen für die Metallisierungsstreifen der beanspruchten Reflektoren sehr ähnlich sind. Ziel der Struktur dieser Druckschrift ist, eine Filtercharakteristik zu erreichen, die bei vorgegebenem Durchlaßband möglichst breite, sich anschließende Stopbänder aufweist und insbesondere auch verbesserte Phasenlinearität besitzt.

Es wurde festgestellt, daß ein Oberflächenwellen-Resonatorfilter nach der europäischen Patentanmeldung 01 24 019 hinsichtlich seiner elektrischen Filtereigenschaften noch weiter optimiert werden kann. Die Aufgabe dieser Optimierung wird durch ein Oberflächenwellen-Resonatorfilter gelöst, das die Merkmale des Patentanspruches 1 aufweist und weitere Ausgestaltungen und weiterbildungen der Erfindung gehen aus den Unteransprüchen hervor.

Der vorliegenden Erfindung liegt die Erkenntnis zugrunde, daß mit den mit dem Oberflächenwellen-Resonatorfilter nach der europäischen Anmeldung 01 24 019 erzielten Verbesserungen ein gewisses Maß an veringertem Reflexionsverhalten der betreffenden Reflektorstruktur einhergeht. Es wurde festgestellt, daß eine weitere Verbesserung dadurch erzielt werden kann, daß man diejenigen Teilstücke der Metallisierungsstreifen der betreffenden Reflektorstruktur, die floatendes Potential haben, d. h. beim bekannten Filter keine elektrische Verbindung aufweisen, hinsichtlich ihres elektrischen Potentials in Bezug auf benachbarte Teilstücke benachbarter Metallisierungsstreifen festlegt. Erfindungsgemäß sind Verbindungsmetallisierungen vorgesehen, die zwei jeweils benachbarte Teilstücke von zwei entsprechend benachbarten Metallisierungsstreifen miteinander elektrisch verbinden. Die Teilstücke eines jeweiligen Metallisierungsstreifens bleiben durch die nach der obengenannten europäischen Patentanmeldung vorgesehenen Unterbrechungen weiterhin elektrisch voneinander getrennt. Insbesondere sind dementsprechend diese Verbindungsmetallisierungen nur zwischen jeweils solchen zwei Teilstücken zweier benachbarter Metallisierungsstreifen vorzusehen, von denen keines außerdem noch mit einem weiteren Teilstück des jeweils anderen Metallisierungsstreifens verbunden ist. D.h., daß die Verbindungsmetallisierungen derart verteilt angeordnet sind, daß nicht über zwei Metallisierungsverbindungen zwischen Teilstücken zweier benachbarter Metallisierungsstreifen doch wieder eine elektrische Verbindung zwischen zwei Teilstücken eines einzelnen jeweiligen Metallisierungsstreifens auftreten.

Bei der vorliegenden Erfindung ist es nicht zwingend erforderlich, daß die bzw. eine gesamte Reflektorstruktur in der erfindungsgemäßen Weise ausgeführt ist. Es kann auch ausreichend sein, wenn nur ein (in Richtung parallel der Wellenausbreitung gesehener) Anteil der Reflektorstruktur in erfindungsgemäßer Weise mit Unterbrechungen und mit Verbindungsmetallisierungen versehen ist. Vorzugsweise ist für die Reflektorstruktur bzw. für einen solchen Anteil eine jeweils gleich große Anzahl von Unterbrechungen für einen jeden (mit Unterbrechungen versehenen) Metallisierungsstreifen vorgesehen. Es kann auch von Vorteil sein, mehrere (in derselben Ausbreitungsrichtung aufeinanderfolgende) Anteile der Reflektorstruktur in erfindungsgemäßer Weise auszubilden und für einen jeweiligen Anteil eine (innerhalb des jeweiligen Anteils konstante) Anzahl von Unterbrechungen der einzelnen Metallisierungsstreifen vorzusehen, die verschieden ist von der Anzahl der Unterbrechungen eines jeweiligen Metallisierungsstreifens eines anderen Anteils. Bevorzugte Anzahl von Unterbrechungen liegt zwischen zwei und fünf. Z.B. kann ein Anteil zwei Unterbrechungen ein anderer Anteil fünf Unterbrechungen haben. Sinngemäß kann auch ein Anteil der Reflektorstruktur überhaupt keine Unterbrechungen aufweisen, wobei ein solcher Anteil insbesondere an das jeweilige Ende einer Reflektorstruktur gelegt wird, wo der Reflexionseinfluß einer solchen Struktur ohnehin nur vermindert stark ist.

Vorzugsweise ist auch bei einem Resonatorfilter der vorliegenden Erfindung die Länge der Unterbrechungen etwa in der Größe der Fingerbreiten bemessen. Vorzugsweise sind auch hier die Unterbrechungen zufallsmäßig verteilt. Für die Metallisierungsverbindungen wird vorzugsweise eine Breite (gemessen quer zur Wellenausbreitungsrichtung) vorgesehen, die etwa in der Größe der Fingerbreite liegt.

Bei einem erfindungsgemäßen Resonatorfilter empfiehlt es sich, die jeweiligen endständigen Teilstücke eines jeweiligen Metallisierungsstreifens in der Art eines jeweiligen Bus-Bars zu verbinden, d. h. eine solche Reflektorstruktur besitzt Bus-Bars in an sich bekannter Ausführungsform. Vorteilhafterweise ist bei der Erfindung vorgesehen, die Anzahl m der Unterbrechungen eines jeweiligen Metallisierungsstreifens (eines Reflektoranteils) auf die Länge des jeweiligen Metallisierungsstreifens so verteilen, daß sich die jeweils erste Unterbrechung sämtlicher Metallisierungsstreifen (dieses Anteils) in einer ersten Zone, sämtliche zweite Unterbrechungen aller Metallisierungsstreifen in einer zweiten Zone usw. befinden. Diese Zonen erstrecken sich streifenförmig parallel der Wellenausbreitungsrichtung und sind parallel dieser Ausbreitungsrichtung nebeneinander angeordnet. Diese z. B. 2, 3, 4 oder 5 nebeneinander liegenden Zonen, die in einem Anteil der Reflektorstruktur mit 2, 3, 4 oder 5 Unterbrechungen für einen jeden Metallisierungsstreifen vorgesehen sind, können äquidistante Breite haben. Die lagemäßige Verteilung der Unterbrechungen zueinander, die schon ein wesentlicher Gewichtspunkt der obengenannten europäischen Patentanmeldung war ist vorzugsweise auf die jeweilige Zone bezogen. Z. B. sind in einer jeden einzelnen Zone die Unterbrechungen zufallsmäßig verteilt. Es kann aber auch eine andere Verteilung, z. B. eine sinusförmige Verteilung innerhalb einer jeweiligen Zone vorgesehen sein. Eine solche gedachtermaßene Aufteilung eines jeweiligen Anteils bzw. der gesamten Reflektorstruktur in einzelne Zonen erleichtert die Erstellung des Entwurfes für diese Resonaturstruktur mit Verbindungsmetallisierungen gemäß der vorliegenden Erfindung. Diese Aufteilung in Zonen gewährleistet, daß jedes Teilstück eines jeden Metallisierungsstreifens mit einem Teilstück eines benachbarten Metallisierungsstreifens verbunden werden kann, ohne daß damit elektrische Verbindungen von Teilstücken eines Metallisierungsstreifens untereinander vorgesehen werden müßen um floatende Teilstücke zu vermeiden.

Weitere Erläuterungen der Erfindung gehen aus der beigefügten Figur hervor.

Die Figur zeigt ein Oberflächenwellen-Resonatorfilter mit variierten Ausgestaltungen gemäß der vorliegenden Erfindung.

In der Figur bedeuten:
- 1: Resonatorfilter,
- 2: Substrat aus z. B. Lithiumniobat,
- 3: Eingangs- und/oder Ausgangswandler in interdigitaler Ausführung,
- 4: gesamte Reflektorstruktur, bezogen auf den Wandler 3 in Richtung der Wellenausbreitung x angeordnet,
- 5, 6: Anteile der Reflektorstruktur 4 mit Unterbrechungen 11 der Metallisierungsstreifen 12 der Reflektorstruktur 4
- 7: Anteil einer Reflektorstruktur 4 ohne Unterbrechungen
- 11: Unterbrechungen eines Metallisierungsstreifens
- 12: Metallisierungsstreifen einer Reflektorstruktur 4
- 104: weitere Reflektorstruktur
- 21 bis 23 121 bis 125: Zonen, in denen eine jeweilige Unterbrechung 11 eines jeweiligen Metallisierungsstreifens 12 vorliegt.
- 26, 27: Bus-Bars
- 112, 212 bis 612: (Elektrodenfinger-) Teilstücke
- 30: Verbindungsmetallisierungen

## Patentansprüche

1. Oberflächenwellen-Resonatorfilter
mit wenigstens zwei separaten Reflektorstrukturen (4, 104), bestehend aus Metallisierungsstreifen und mit wenigstens einem Interdigitalwandler (3) auf einem Substrat (2) aus piezoelektrischem Material, in dem eine Wellenausbreitung in zu den Metallisierungsstreifen senkrechter Richtung (x) vorliegt, und wobei diese Metallisierungsstreifen in Querrichtung (y) zu dieser Wellenausbreitung (x) mehrfach unterbrochen (11) sind,
wobei in wenigstens einer Reflektorstruktur in wenigstens einem Anteil derselben wenigstens eine Vielzahl der Metallisierungsstreifen zueinander verteilt angeordnete Unterbrechungen (11) in Richtung (y) der Metallisierungsstreifen aufweist,
- wobei diese Reflektorstruktur (4) wenigstens in einem in Richtung der Wellenausbreitungsrichtung (x) gesehenen mehrere Metallisierungsstreifen (12) umfassender Anteil (5, 6) derselben die gleiche Anzahl der Unterbrechungen (11) dieser mehreren Metallisierungsstreifen (12) aufweist, gekennzeichnet dadurch
- daß dieser Anteil (5, 6) in eine gleich der Anzahl der Unterbrechungen (11) gleich große Anzahl von zur Wellenausbreitungsrichtung (x) parallelen Streifenzonen (21 bis 23; 121 bis 125) gedachtermaßen aufgeteilt ist und im Bereich einer jeden dieser Streifenzonen nur jeweils eine Unterbrechung (11) eines jeweils unterteilten Metallisierungsstreifen (12) vorliegt,
- wobei diese Unterbrechungen (11) innerhalb einer solchen jeweiligen Streifenzone zueinander verteilt angeordnet sind und
- daß in Richtung der Wellenausbreitungsrichtung (x) verlaufende Verbindungsmetallisierungen (30) zwischen benachbarten Teilstücken (112, 212 bis 612) benachbarter Metallisierungsstreifen (12) vorgesehen sind, mit denen jedes Teilstück eines Metallisierungsstreifens mit jeweils einem benachbarten Teilstück eines benachbarten Metallisierungsstreifens elektrisch verbunden ist, wobei keine solchen Verbindungen vorliegen, die im Ergebnis zu elektrischen Verbindungen zweier Teilstücke ein und desselben Metallisierungsstreifens führen.

2. Oberflächenwellen-Resonatorfilter nach Anspruch 1, **gekennzeichnet** dadurch, daß eine solche Reflektorstruktur (4) mehrere solche Anteile (5, 6) mit Unterbrechungen (11) der Metallisierungsstreifen (12) und mit Verbindungsmetallisierungen (30) zwischen den Teilstücken aufweist, wobei diese Anteile voneinander verschiedene Anzahl Unterbrechungen der Metallisierungsstreifen aufweisen.

3. Oberflächenwellen-Resonatorfilter nach Anspruch 1 oder 2, **gekennzeichnet** dadurch, daß diese Reflektorstruktur (4) auch einen Anteil (7) mit Metallisierungsstreifen (12) hat, die frei von Unterbrechungen sind.

4. Oberflächenwellen-Resonatorfilter nach einem der Ansprüche 1 bis 3, **gekennzeichnet** dadurch, daß die Anzahl der Unterbrechungen (11) der Metallisierungsstreifen (12) zwischen 2 und 5 liegt.

5. Oberflächenwellen-Resonatorfilter nach einem der Ansprüche 1 bis 4, **gekennzeichnet** dadurch, daß die Unterbrechungen innerhalb einer Streifenzone (21 bis 23; 121 bis 125) der Reflektorstruktur (4) zufallsverteilt angeordnet sind.

6. Oberflächenwellen-Resonatorfilter nach einem der Ansprüche 1 bis 5, **gekennzeichnet** dadurch, daß die Verbindungsmetallisierungen (30) der jeweils endständigen Teilstücke der Metallisierungsstreifen (112 und 612) als Bus-Bars (26, 27) ausgebildet sind.

7. Oberflächenwellenresonatorfilter nach einem der Ansprüche 1 bis 6, **gekennzeichnet** dadurch, daß die Unterbrechungen (11) der Metallisierungsstreifen (12) in etwa der Größe der Breite der Metallisierungsstreifen bemessen sind.

8. Oberflächenwellen-Resonatorfilter nach einem der Ansprüche 1 bis 7, **gekennzeichnet** dadurch, daß die Verbindungsmetallisierungen (30) mit einer Breite (quer zur Wellenausbreitungsrichtung (x)) etwa in der Größe der Breite der Metallisierungsstreifen (12) bemessen sind.

## Claims

1. Surface-wave resonator filter having at least two separate reflector structures (4, 104), comprising metallisation strips, and having at least one interdigital transducer (3) on a substrate (2) composed of piezo-electric material, in which wave propagation occurs in a direction (x) at right angles to the metallisation strips, and these metallisation strips having multiple interruption (11) in the direction (y) at right angles to this wave propagation (x), at least a multiplicity of metallisation strips having interruptions (11), which are arranged distributive with respect to one another, in the direction (y) of the metallisation strips in at least one reflector structure in at least one portion of the same, this reflector structure (4) having the same number of interruptions (11) in this plurality of metallisation strips (12) at least in a portion (5, 6) of the same, seen in the direction of the wave propagation direction (x) and comprising a plurality of metallisation strips (12), characterised in that
- this portion (5, 6) is divided in an imaginary manner into a number of strip zones (21 to 23; 121 to 125) which are parallel to the wave propagation direction (x) and which number is equal to the number of interruptions (11), and there is in each case only one interruption (11) in a respectively divided metallisation strip (12) in the region of each of these strip zones,
- these interruptions (11) being arranged distributive with respect to one another within in each case one such strip zone, and
- in that connecting metallisations (30) running in the direction of the wave propagation direction (x) are provided between adjacent subelements (112, 212 to 612) of adjacent metallisation strips (12), by means of which each subelement of a metallisation strip is electrically connected to in each case one adjacent subelement of an adjacent metallisation strip, there being no such connections which, in their effect, lead to electrical connections of two subelements of one and the same metallisation strip.

2. Surface-wave resonator filter according to Claim 1, characterised in that one such reflector structure (4) has a plurality of such portions (5, 6) having interruptions (11) in the metallisation strips (12) and having connecting metallisations (30) between the subelements, these portions having a mutually different number of interruptions in the metallisation strips.

3. Surface-wave resonator filter according to Claim 1 or 2, characterised in that this reflector structure (4) also has a portion (7) having metallisation strips (12) which are free of interruptions.

4. Surface-wave resonator filter according to one of Claims 1 to 3, characterised in that the number of interruptions (11) in the metallisation strips (12) is between 2 and 5.

5. Surface-wave resonator filter according to one of Claims 1 to 4, characterised in that the interruptions within one strip zone (21 to 23; 121 to 125) of the reflector structure (4) are arranged in a randomly distributed manner.

6. Surface-wave resonator filter according to one of Claims 1 to 5, characterised in that the connecting metallisations (30) of the subelements of the metallisation strips (112 and 612) which are located at the end in each case are constructed as busbars (26, 27).

7. Surface-wave resonator filter according to one of Claims 1 to 6, characterised in that the interruptions (11) in the metallisation strips (12) are dimensioned to approximately the size of the width of the metallisation strips.

8. Surface-wave resonator filter according to one of Claims 1 to 7, characterised in that the connecting metallisations (30) are dimensioned with a width (at right angles to the wave propagation direction (x)) of approximately the size of the width of the metallisation strips (12).

## Revendications

1. Filtre-résonateur à ondes de surface comportant au moins deux structures réfléchissantes séparées (4,5), constituées par des bandes de métallisation et au moins un transducteur interdigité (3) situé sur un substrat (2), réalisé en un matériau piézoélectrique, dans lequel se présente une propagation des ondes dans une direction (x) perpendiculaire aux bandes de métallisation, et
dans lequel ces bandes de métallisation présentent de multiples interruptions (11) dans une direction (y) transversale par rapport à cette propagation (x) des ondes, et dans lequel, dans au moins une structure réfléchissante et dans au moins une partie de cette structure, au moins plusieurs bandes de métallisation possèdent, dans leur direction (y), des interruptions (11) réparties entre les différentes bandes, et
dans lequel cette structure réfléchissante (4) possède, au moins dans une partie (5,6) qui comprend plusieurs bandes de métallisation (12) prévues dans la direction (x) de propagation des ondes, le même nombre d'interruptions dans ces bandes de métallisation (12),
caractérisé en ce
- que cette partie (5,6) est subdivisée fictivement en un nombre, égal au nombre des interruptions (11), de zones de bandes (21 à 23; 121 à 125) parallèles à la direction (x) de propagation des ondes et que seule, respectivement, une interruption (11) d'une bande respective de métallisation subdivisée (12) est présente dans la région de chacune de ces zones en forme de bandes,
- les interruptions (11) étant disposées en étant réparties entre elles dans une telle zone respective en forme de bande, et
- que des métallisations de liaison (30), qui s'étendent dans la direction (x) de propagation des ondes, sont prévues entre des éléments partiels voisins (112,212 à 612) de bandes voisines de métallisation (12), à l'aide desquelles chaque élément partiel d'une bande de métallisation est raccordé électriquement respectivement à un élément partiel voisin d'une bande de métallisation voisine, s'il n'existe pas de telles liaisons, qui conduisent à l'établissement de liaisons électriques de deux éléments partiels d'une même bande de métallisation.

2. Filtre-résonateur à ondes de surface suivant la revendication 1, caractérisé par le fait qu'une telle structure réfléchissante (4) comporte plusieurs parties de ce type (5,6), dans lesquelles il existe des interruptions (11) dans les bandes de métallisation (12) et des métallisations de liaison (30) entre les éléments partiels, ces parties possédant des nombres différents d'interruptions dans les bandes de métallisation.

3. Filtre-résonateur à ondes de surface suivant la revendication 1 ou 2, caractérisé par le fait que cette structure réfléchissante (4) possède également une partie (7) comportant des bandes de métallisation (12) qui ne comportent aucune interruption.

4. Filtre-résonateur à ondes de surface suivant l'une des revendications 1 à 3, caractérisé par le fait que le nombre des interruptions (11) des bandes de métallisation (12) est compris entre 2 et 5.

5. Filtre-résonateur à ondes de surface suivant l'une des revendications 1 à 4, caractérisé par le fait que les interruptions sont disposées en étant réparties de façon aléatoire à l'intérieur d'une zone en forme de bande (21 à 23; 121 à 125) de la structure réfléchissante (4).

6. Filtre-résonateur à ondes de surface suivant l'une des revendications 1 à 5, caractérisé par le fait que les métallisations de liaison (3) des éléments partiels respectifs finals obtenus des bandes de métallisation (112 et 612) sont agencés sous la forme de barres omnibus (26,27).

7. Filtre-résonateur à ondes de surface suivant l'une des revendications 1 à 6, caractérisé par le fait que les interruptions (11) des bandes de métallisation (12) sont dimensionnées de manière à avoir une taille correspondant approximativement à la largeur des bandes de métallisation.

8. Filtre-résonateur à ondes de surface suivant l'une des revendications 1 à 7, caractérisé par le fait que les métallisations de liaison (30) sont dimensionnées avec une largeur (comptée transversalement par rapport à la direction (x) de propagation des ondes), qui est égale approximativement à la largeur des bandes de métallisation (12).
